# EUROPEAN PATENT APPLICATION

(11) **EP 4 622 402 A1**
(43) Date of publication of application: **24.09.2025**
(21) Application number: 24165358.3
(22) Date of filing: 21.03.2024
(51) Int. Cl.: H05K 1/05, H05K 3/44, F21V 21/096, F21V 21/35

(54) **METHOD FOR FORMING IRON-BASED CONDUCTIVE PLATE, IRON-BASED CONDUCTIVE PLATE AND MAGNETIC ABSORPTION TRACK LAMP THEREOF**

(71) Applicant: Shenzhen Huayu circuits Co., Ltd, Shenzhen (CN)
(72) Inventor: LIU, Hong, Shenzhen (CN)
(74) Representative: Lin Chien, Mon-Yin

(57) **Abstract**

A method for forming an iron-based conductive plate includes: cutting materials, cutting a preset whole large plate material into iron plates of preset sizes; performing copper coating, taking a black insulation semi-cured sheet as a bonding material, covering upper and lower surfaces of the iron plate with copper foil to obtain an iron-based covering plate; performing transfer of circuit graphics, transferring conductive circuit graphics to surfaces of the iron-based copper-clad plate, and thickening the copper foil on the circuit that needs to be processed, covering with a layer of tin metal on the circuit that needs to be processed; etching circuits, removing the copper foil without covering the tin metal through an etching solution, etching circuit diagrams to obtain circuit boards; electroplating conductive films on the etched circuit diagrams; performing screen printing texts; drilling target holes, performing gong carving and performing V-cut molding; performing functional testing and performing outgoing inspection.

## Description

### TECHNICAL FIELD

The present disclosure generally relates to the field of lighting devices and low-voltage rail power supply technologies, and especially relates to a method for forming an iron-based conductive plate, an iron-based conductive plate and a magnetic absorption track lamp thereof.

### BACKGROUND

A conventional conductive substrate on the market has a structure of an aluminum based metal plate, an insulation layer and a copper foil. After the conventional conductive plate is manufactured, it needs to perform lead-free tin spraying, oxidation resistance, chemical nickel gold deposition, electrolytic nickel gold, silver deposition, or carbon oil printing processing on surfaces of the copper foil. Such type of aluminum-based conductive substrate is applied in the field of various electronic products, and is also widely used in the field of magnetic absorption track lamps. This type of magnetic absorption track lamp includes a base and a light emitting element, an aluminum substrate and a plurality of small iron blocks respectively installed on the base, the light emitting element slidably arranged on the magnetic absorption track lamp, and including a magnet. The light emitting element is positioned on the base through a magnetic force between the magnet and the small iron block, and positions of the light emitting element can be adjusted arbitrarily on the magnetic absorption track lamp. However, the base of this type of aluminum substrate is to install the plurality of small iron blocks for absorbing the light emitting element, resulting in a larger size of the base of the magnetic absorption track lamp, which increases the overall size of the magnetic absorption track lamp, as well as assembly costs, packaging costs and material costs thereof. Therefore, it is necessary to improve the above structure. The present disclosure has designed an iron-based conductive plate.

The present disclosure provides a new iron-based conductive plate to perform a black conductive film treatment process on surfaces of the iron-based conductive plate, which not only can maintain conductivity, prevent oxidation and present a black appearance.

The conductive plate of the present disclosure can be directly applied to the field of magnetic absorption track lamps. The iron-based conductive plate itself can be used for absorbing a light emitting module of the magnetic absorption track lamp, rather than adding additional metal small pieces to magnetically absorb the light emitting module, in this way, the size of the base of the magnetic absorption track lamp can be reduced, thereby reducing an overall size of the lamp and material costs, installation costs and packaging costs thereof.

### SUMMARY

The technical problems to be solved: in view of the shortcomings of the related art, the present disclosure provides a method for forming an iron-based conductive plate, an iron-based conductive plate and a magnetic absorption track lamp thereof which can perform a black conductive film treatment process on surfaces of the iron-based conductive plate, so that the present disclosure not only can maintain conductivity, prevent oxidation, resist friction and present a black appearance, but also can be directly applied to magnetic absorption track lamps, conveniently replace and slide light emitting modules thereof.

In a first aspect, a method for forming an iron-based conductive plate according to an embodiment of the present disclosure includes:
step S 1, cutting materials, cutting a preset whole large plate material into iron plates of preset sizes;
step S2, performing copper coating, taking a black insulation semi-cured sheet as a bonding material, and covering upper and lower surfaces of the iron plate with copper foil to obtain an iron-based covering plate;
step S3, performing transfer of circuit graphics, transferring conductive circuit graphics to surfaces of the iron-based copper-clad plate, and thickening the copper foil on the circuit that needs to be processed, covering with a layer of tin metal on the circuit that needs to be processed;
step S4, etching circuits, removing the copper foil without covering the tin metal through an etching solution, etching circuit diagrams to obtain circuit boards;
step S5, electroplating conductive films on the etched circuit diagrams;
step S6, performing screen printing texts;
step S7, drilling target holes, performing gong carving and performing V-cut molding; and
step S8, performing functional testing and performing outgoing inspection.

In a second aspect, an iron-based conductive plate according to an embodiment of the present disclosure is formed by the method above mentioned.

In a third aspect, a magnetic absorption track lamp according to an embodiment of the present disclosure includes the iron-based conductive plate above mentioned.

The present disclosure provides the advantages as below: the present disclosure provides the method for forming the iron-based conductive plate, the iron-based conductive plate and the magnetic absorption track lamp thereof, so that the present disclosure can perform a black conductive film treatment process on surfaces of the iron-based conductive plate, which not only can maintain conductivity, prevent oxidation, resist friction and present a black appearance, but also can be directly applied to magnetic absorption track lamps, conveniently replace and slide light emitting modules thereof.

### BRIEF DESCRIPTION OF THE DRAWINGS

In order to more clearly understand the technical solution hereinafter in embodiments of the present disclosure, a brief description to the drawings used in detailed description of embodiments hereinafter is provided thereof. Obviously, the drawings described below are some embodiments of the present disclosure, for one of ordinary skill in the related art, other drawings can be obtained according to the drawings below on the premise of no creative work.
FIG. 1 is a schematic flowchart of a method for forming an iron-based conductive plate in accordance with an embodiment of the present disclosure.
FIG. 2 is a schematic view of a magnetic absorption track lamp in accordance with an embodiment of the present disclosure.
FIG. 3 is an exploded, schematic view of the magnetic absorption track lamp of FIG. 2.
FIG. 4 is a schematic view of a power supply of the magnetic absorption track lamp of FIG. 2.
FIG. 5 is a schematic view of a light emitting element of the magnetic absorption track lamp of FIG. 2.

The element labels according to the embodiment of the present disclosure shown as below:
10 movable rail, 11 first clamping portion, 12 second clamping portion, 20 light emitting element, 21 movable block, 211 first body, 212 first sliding portion, 213 first magnet, 214 first contact, 22 connecting shaft,23 light emitting module, 30 power supply, 31 second body, 32 second sliding portion, 33 second magnet, 34 second contact, 40 iron-based conductive plate, 50 rubber strip, 51 clamping member.

### DETAILED DESCRIPTION

Reference will now be made in detail to embodiments, examples of which are illustrated in the accompanying drawings. In the following detailed description, numerous specific details are set forth in order to provide a thorough understanding of the subject matter presented herein. Obviously, the implementation embodiment in the description is a part of the present disclosure implementation examples, rather than the implementation of all embodiments, examples. According to the described exemplary embodiment of the present disclosure, all other embodiments obtained by one of ordinary skill in the related art on the premise of no creative work are within the protection scope of the present disclosure.

The flowchart shown in the accompanying drawings is only taken as an example without necessarily including all contents and operations/steps, nor does it have to be performed in an order which is described. For example, some operations/steps can also be decomposed, combined or partially merged, so actual execution orders can be changed according to actual situations.

The present disclosure provides a method for forming an iron-based conductive plate, an iron-based conductive plate and a magnetic absorption track lamp thereof. The method can be performed to form the iron-based conductive plate which can be applied to the magnetic absorption track lamp. The iron-based conductive plate of the present disclosure can be directly exposed, and surfaces of the iron-based conductive plate can be treated with a black conductive film treatment process, which can maintain conductivity and prevent oxidation. The light emitting module of the magnetic absorption track lamp has a strong wear resistance when the light emitting module sliding on the iron-based conductive plate, a long service life and good visual experiences.

A detailed explanation of some implementation methods of the present disclosure will now be made below, which is combined with the accompanying drawings. The following embodiments and features can be combined with each other in an absence of conflict.

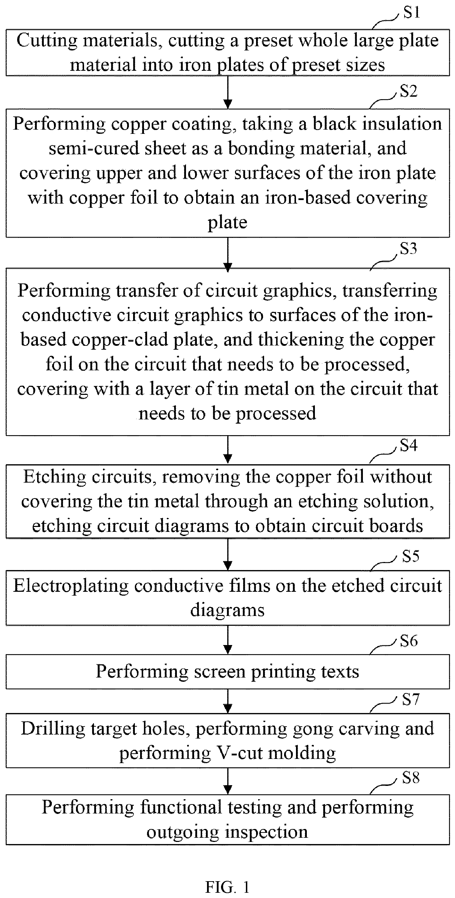

Referring to FIG. 1, FIG. 1 is a schematic flowchart of a method for forming an iron-based conductive plate in accordance with an embodiment of the present disclosure. The method includes steps S1 to S8.

Step S1, cutting materials, cutting a preset whole large plate material into iron plates of preset sizes.

In an embodiment of the present disclosure, the preset size of the iron plate is determined based on a size of the conductive plate, a length and a width of the iron plate are usually slightly larger than those of the conductive plate.

Cutting the whole large plate material with the present size into a plurality of plates with engineering layout dimensions by a cutting device, and then placing the plurality of plates with engineering layout dimensions in a rounding machine for grinding the plurality of plates. At the same time, turning on a vacuum cleaner to remove fragments until four right angles of each plate are rounded.

Step S2, performing copper coating, taking a black insulation semi-cured sheet as a bonding material, and covering upper and lower surfaces of the iron plate with copper foil to obtain an iron-based covering plate.

Flatting the black insulation semi-cured sheet as an adhesive material and placing the black insulation semi-cured sheet on a double-sided iron plate, covering the upper and lower surfaces with the copper foil. When multi-layer plates need to be made, the above operation can be repeated to stack a plurality of plates. Subsequently, a product that has already been covered with the copper foil is pushed into a high-temperature and high-pressure pressing device, to bond each layer of plate into a whole using the semi-cured sheet.

This type of bonding way is obtained that macromolecules at interfaces among the plates are occurred through mutual diffusion, permeation and cross-linking, so that the above entire process includes three stages: a kiss pressing stage, a full pressing stage and a cold pressing stage. During the kiss pressing stage, resin in the semi-cured sheet is melted into low viscosity resin, bubbles are expelled, and a dynamic viscosity of the resin is gradually increased. When entering the full pressing stage, an exhaust, gap filling, and even distribution of the resin's curing and crosslinking reaction are completely completed. Next, in the cold pressing stage, the plate maintains dimensional stability during performing rapid cooling, ultimately resulting in a required double-sided copper-clad plate.

Step S3, performing transfer of circuit graphics, transferring conductive circuit graphics to surfaces of the iron-based copper-clad plate, and thickening the copper foil on the circuit that needs to be processed, covering with a layer of tin metal on the circuit that needs to be processed.

The step S3 includes steps S301-S303:
step S301, cleaning and brushing the iron-based copper-clad plate, drying the iron-based copper-clad plate, and then applying photosensitive ink on the iron-based copper-clad plate;
step S302, by using photochemistry principles, performing exposure and development on a configuration of the graphic circuits through a roll of film, and transferring the configuration of the graphic circuits to the iron-based copper-clad plate; and by using chemical principles, performing development and film removal for removing unnecessary ink to produce desired graphic circuits;
step S303, by using an electroplating device, performing electrochemical reaction on the circuit board that has been completely performed graphic transfer, to adsorb copper ions onto the copper foil of the circuit board that needs to be processed, thickening the copper foil and covering with the layer of tin metal on the circuit board that needs to be processed. The copper foil is then thickened and covered with the layer of tin metal to protect the copper foil of the circuit board that needs to be processed.

Step S4, etching circuits, removing the copper foil without covering the tin metal through an etching solution, etching circuit diagrams to obtain circuit boards.

The step S4 includes steps S401-S403:
step S401, performing development on remaining ink by using a chemical cleaning way for developing the remaining ink clean, so as to expose un-tined copper foil;
step S402, etching the copper foil that is exposed by using an etching solution to obtain a clean insulation substrate; and
step S403, performing chemical cleaning on a tin metal that has been electroplated to obtain a complete circuit drawing sheet.

Step S5, electroplating conductive films on the etched circuit diagrams.

The step S5 includes steps S501-S502.

Step S501, cleaning oil films, impurities and oxide layers of the copper foil.

Step S502, performing pickling and prepreg on the copper foil that has been cleaned, electroplating a layer of conductive film on a conductive surface of the copper foil to turn surfaces of the circuit copper foil black and maintain conductivity of the copper foil.

In some embodiments of the present disclosure, after the step S5, the method further includes: coating solder mask paint-coat. A thin layer of polymer coated with solder mask is placed on the circuit board to protect copper from being oxidation and short circuits during operation, which can also protect conductive substrates from environmental influences.

The step of coating solder mask paint-coat includes:
cleaning circuits to remove dirt and other pollutants, and then drying surfaces of the circuit board;
loading the circuit board into a vertical coating machine for performing solder mask ink coating, to add the solder mask paint-coat to the entire circuit board;
pre-hardening, performing low-temperature rapid preliminary hardening on the circuit board, covering the circuit board with prepared solder mask graphic film, and performing partial aggregation on layers through photochemical reactions; and
performing development and rinse on the circuit board by using liquid medicine to easily remove unexposed coating from the circuit board.

Step S6, performing screen printing texts.

Products that need to be described in terms of specifications, performances, and logo symbols are performed screen printing by using character ink to be printed, and then performed high-temperature baking and curing, in this way, solder mask and text ink can be completely covered on the circuit board.

Step S7, drilling target holes, performing gong carving and performing V-cut molding.

The step of drilling target holes is to provide an origin positioning for subsequent machining processes. The steps of performing gong carving and performing V-cut molding are as follows:
On a CNC gong board machine, drilling a pin hole that coincides with the target hole, inserting a pin into the pin hole, providing a reference point for the circuit board, and then placing 3-5 pieces of circuit boards on the pin hole to complete a preparation work.

Turning on the device, retrieving drawings, and performing gong board cutting or laser cutting operations on the circuit board to separate the circuit board from other identical products with and/or layouts.

Performing V-cut cutting for products that can be processed in a straight line, and the layout of the products can also be separated.

Step S8, performing functional testing and performing outgoing inspection.

After the product is completely produced, an open circuit and a short circuit test is required. For a wiring part that needs to be added, it is necessary to check accuracy of the drawings, and electrical performance also needs to be checked to ensure integrity of functions of the circuit board. After the functional testing is completed, a visual inspection is occurred, and after the inspection is completed, the product can be packaged to be shipped.

The above implementation example is a production process of a conductive plate with a single-sided conductive bottom for electricity collection. When producing a conductive plate with a double-sided conductive bottom for electricity collection, some additional steps need to be added.

After the step S1, the method further includes step S11, drilling a hole once, drilling a first through-hole at a position designed on the iron plate, and filling epoxy resins into the first through-hole.

First, drilling the first through-hole on the iron plate according to a designed position by using a drilling rig, filling epoxy resin into the first through-hole, and then grinding the first through-hole that has been filled epoxy resin to level the first through-hole.

Specific steps for the step of drilling the first through-hole are:
Step S111, preparing the iron plates that need to be drilled, each board usually includes 3-6 pieces (depending on actual production situations), with the top layer being a lower cushion plate, a middle layer being the iron plate, and the bottom being an upper cushion plate. Moving a spindle seat to the position where the hole is needed to be drilled, drilling holes and installing pins in the holes. Repeating the above operation for 3-4 corner positions in sequence.
Step S112, placing each stack of iron plates that are installed the pins on a workbench of the drilling machine, laying a layer of aluminum sheets to fix the stack of boards, and setting an origin point of the stack of boards.
Step S113, the drilling rig is reset based on the origin point and begins to perform full board drilling operations according to drilling data.

After the step S2, the method further includes:
step S21, drilling a second through-hole in the epoxy resin that is filled in the step S11, and covering a layer of copper on surfaces of the second through-hole through a copper deposition process.

Specifically, before performing copper deposition, the iron-based copper-clad plate is cleaned and ground to obtain a clean copper foil, providing a perfect surface foundation for subsequent copper deposition operations. On a non-conductive hole-wall substrate that has been drilled and the previously covered copper foil, a thin layer of chemical copper is chemically deposited as the substrate for performing subsequent copper plating.

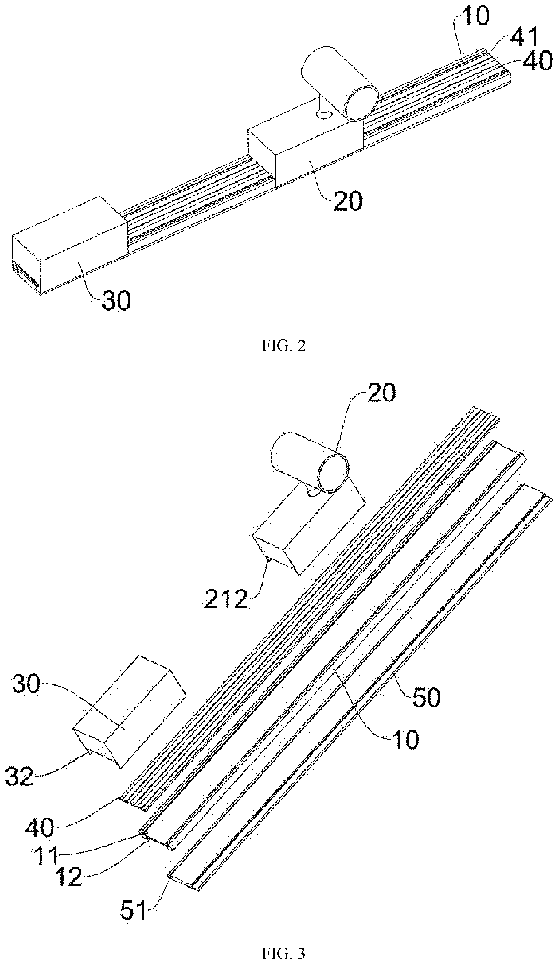

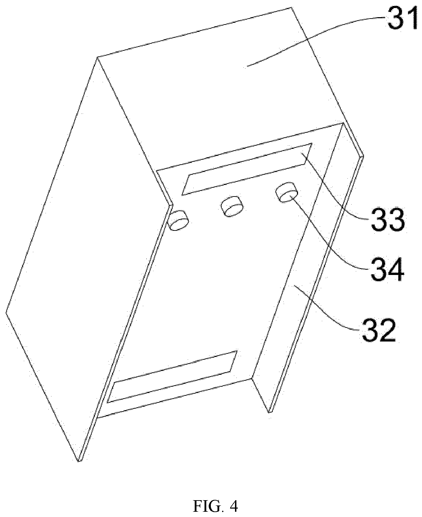

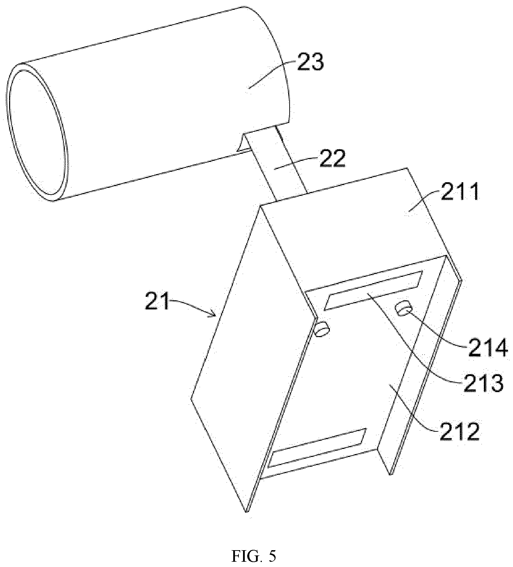

Referring to FIG. 2 to FIG. 5, a magnetic absorption track lamp according to an embodiment of the present disclosure includes: a movable rail 10, a light emitting element 20, a power supply 30 and an iron-based conductive plate 40 that is formed by the above method. The iron-based conductive plate 20 is installed on the movable rail 10, and both the light emitting element 20 and the power supply 30 are slidably arranged on the movable rail 10. The light emitting element 20 and the power supply 30 are detachable components that can be disassembled manually. After fixing the movable rail 10 with the iron-based plate to an external wall or other fixed positions, both the light emitting element 20 and power supply 30 can be installed on the movable rail 10, in this way, users can freely adjust positions of the light emitting element 20 on the movable rail 10 to illuminate objects or environments to be illuminated.

A first clamping portion 11 is arranged on a side of the movable rail 10 towards the light emitting element 20, the iron-based conductive plate 40 clamped with the first clamping portion 11. A size of the iron-based conductive plate 40 matches with a size of the first clamping portion 11 to ensure that the iron-based conductive plate 40 can be fixed in the first clamping portion 11. It should be noted that a length of the movable rail 10 in the accompanying drawings of the present disclosure is only a schematic length, which is not n actual length of the product.

The light emitting element 20 includes a movable block 21 slidably arranged on the movable rail 10, a connecting shaft 22 and a light emitting module 23; one end of the connecting shaft 22 connected to the movable block 21, and the other end of the connecting shaft 22 connected to the light emitting module 23. In order to allow the light emitting module 23 to rotate freely and illuminate in different directions, the connecting shaft 22 can be rotatably connected to the light emitting module 23, and the connecting shaft 22 can also be rotatably connected to the movable block 21.

The movable block 21 includes a first body 211, a first sliding portion 212, a first magnet 213 and a first contact 214; the first sliding portion 212 arranged on a side of the first body 211 close to the movable rail 10, both the first magnet 213 and the first contact 214 installed on a bottom wall of the first sliding portion 212, the first magnet 213 directly facing the iron-based conductive plate 40, and the first contact 214 abutting against circuits 41 of the iron-based conductive plate 40. When the lamp is used, the first sliding portion 212 slides onto the movable rail 10, and a width of the first sliding portion 212 matches with that of the movable rail 10, so that the movable block 21 can only slide along the movable rail 10. As the iron-based conductive plate 40 is made of an iron-based material, the first magnet 213 can be directly adsorbed on the iron-based conductive plate 40. When it is necessary to adjust a position of the movable block 21, the movable block 21 can be directly slid manually. Such type of substrate of the track lamp on the market is an aluminum substrate, in order to implement magnetic attraction between the light emitting element 20 and the movable rail 10, a plurality of small iron blocks need to be arranged on the movable rail 10 for magnetic adsorption. However, the plurality of small iron blocks is provided to increase the number of components arranged on the movable rail 10 and a thickness of the movable rail 10, which increases installation costs and material costs thereof. However, the present disclosure provides the iron-based conductive plate 40 to avoid such problems. Therefore, the size of the movable rail 10 is greatly reduced, and there is no need to set small iron blocks, reducing costs of assembling the small iron blocks and raw material costs of producing the small iron blocks.

The power supply 30 includes a second body 31, a second sliding portion 32, a second magnet 33 and a second contact 34; the second sliding portion 32 arranged on a side of the second body 31 close to the movable rail 10, both the second magnet 33 and the second contact 34 installed on a bottom wall of the second sliding portion 32, the second magnet 33 directly facing the iron-based conductive plate 40, and the second contact 34 abutting against circuits 41 of the iron-based conductive plate 40. The power supply 30 can be directly absorbed on the movable rail 10 through the second magnet 33, and the second sliding portion 32 is provided that the power supply 30 can only slide along the movable rail 10.

In an optical embodiment of the present disclosure, the magnetic absorption track lamp further includes a rubber strip 50, and a second clamping portion 12 is formed on a side of the movable rail 10 away from the light emitting element 20, the rubber strip 50 including a clamping member 51 snapped into the second clamping portion 12. By setting the rubber strip 50, it is convenient to install the movable rail 10, and insulation protection can be provided for the movable rail 10.

In an embodiment of the present disclosure, the movable rail 10 is a sheet metal reinforcement.

Although the features and elements of the present disclosure are described as embodiments in particular combinations, each feature or element can be used alone or in other various combinations within the principles of the present disclosure to the full extent indicated by the broad general meaning of the terms in which the appended claims are expressed. Any variation or replacement made by one of ordinary skill in the related art without departing from the spirit of the present disclosure shall fall within the protection scope of the present disclosure.

## Claims

1. A method for forming an iron-based conductive plate, which is **characterized in that**, the method comprising:
step S1, cutting materials, cutting a preset whole large plate material into iron plates of preset sizes;
step S2, performing copper coating, taking a black insulation semi-cured sheet as a bonding material, and covering upper and lower surfaces of the iron plate with copper foil to obtain an iron-based covering plate;
step S3, performing transfer of circuit graphics, transferring conductive circuit graphics to surfaces of the iron-based copper-clad plate, and thickening the copper foil on the circuit that needs to be processed, covering with a layer of tin metal on the circuit that needs to be processed;
step S4, etching circuits, removing the copper foil without covering the tin metal through an etching solution, etching circuit diagrams to obtain circuit boards;
step S5, electroplating conductive films on the etched circuit diagrams;
step S6, performing screen printing texts;
step S7, drilling target holes, performing gong carving and performing V-cut molding; and
step S8, performing functional testing and performing outgoing inspection.

2. The method as claimed in claim 1, which is **characterized in that** after the step S1, the method further comprises:
step S11, drilling a hole once, drilling a first through-hole at a position designed on the iron plate,
and filling epoxy resins into the first through-hole; and wherein
after the step S2, the method further comprises:
step S21, drilling a second through-hole in the epoxy resin that is filled in the step S11, and covering a layer of copper on surfaces of the second through-hole through a copper deposition process.

3. The method as claimed in claim 1, which is **characterized in that** the semi-cured sheet and the copper foil of the step S2 are stacked with a plurality of layers according to a designed quantity and an order.

4. The method as claimed in claim 1, wherein the step S3 comprises:
cleaning and brushing the iron-based copper-clad plate, drying the iron-based copper-clad plate,
and then applying photosensitive ink on the iron-based copper-clad plate;
by using photochemistry principles, performing exposure and development on a configuration of the graphic circuits through a roll of film, and transferring the configuration of the graphic circuits to the iron-based copper-clad plate; and by using chemical principles, performing development and film removal for removing unnecessary ink to produce desired graphic circuits; and
by using an electroplating device, performing electrochemical reaction on the circuit board that has been completely performed graphic transfer, to adsorb copper ions onto the copper foil of the circuit board that needs to be processed, thickening the copper foil and covering with the layer of tin metal on the circuit board that needs to be processed.

5. The method as claimed in claim 4, which is **characterized in that** the step S4 comprises:
performing development on remaining ink by using a chemical cleaning way for developing the remaining ink clean, so as to expose un-tined copper foil;
etching the copper foil that is exposed by using an etching solution to obtain a clean insulation substrate; and
performing chemical cleaning on a tin metal that has been electroplated to obtain a complete circuit drawing sheet.

6. The method as claimed in claim 5, which is **characterized in that** the step S5 comprises:
cleaning oil films, impurities and oxide layers of the copper foil; and
performing pickling and prepreg on the copper foil that has been cleaned, electroplating a layer of conductive film on a conductive surface of the copper foil to turn surfaces of the circuit copper foil black and maintain conductivity of the copper foil.

7. The method as claimed in claim 1, which is **characterized in that** after the step S5, the method further comprises: coating solder mask paint-coat on the copper foil.

8. The method as claimed in claim 7, which is **characterized in that** the step of coating solder mask paint-coat on the copper foil comprises:
cleaning circuits to remove dirt and other pollutants, and then drying surfaces of the circuit board;
loading the circuit board into a vertical coating machine for performing solder mask ink coating, to add the solder mask paint-coat to the entire circuit board;
pre-hardening, performing low-temperature rapid preliminary hardening on the circuit board,
covering the circuit board with prepared solder mask graphic film, and performing partial aggregation on layers through photochemical reactions; and
performing development and rinse on the circuit board by using liquid medicine to easily remove unexposed coating from the circuit board.

9. An iron-based conductive plate (40) is formed by the method as claimed in any one of claims 1-8.

10. A magnetic absorption track lamp, which is **characterized in that**, the magnetic absorption track lamp comprising a movable rail (10), a light emitting element (20), a power supply (30) and an iron-based conductive plate (40) as claimed in claim 9, the iron-based conductive plate (40) installed on the movable rail (10), both the light emitting element (20) and the power supply (30) slidably arranged on the movable rail (10).

11. The magnetic absorption track lamp as claimed in claim 10, which is **characterized in that** a first clamping portion (11) is arranged on a side of the movable rail (10) towards the light emitting element (20), the iron-based conductive plate (40) clamped with the first clamping portion (11).

12. The magnetic absorption track lamp as claimed in claim 10, wherein the light emitting element (20) comprises a movable block (21) slidably arranged on the movable rail (10), a connecting shaft (22) and a light emitting module (23), one end of the connecting shaft (22) connected to the movable block (21), and the other end of the connecting shaft (22) connected to the light emitting module (23).

13. The magnetic absorption track lamp as claimed in claim 12, which is **characterized in that** the movable block (21) comprises a first body (211), a first sliding portion (212), a first magnet (213) and a first contact (214); the first sliding portion (212) arranged on a side of the first body (211) close to the movable rail (10), both the first magnet (213) and the first contact (214) installed on a bottom wall of the first sliding portion (212), the first magnet directly (213) facing the iron-based conductive plate (40), and the first contact (214) abutting against circuits of the iron-based conductive plate (40).

14. The magnetic absorption track lamp as claimed in claim 12, which is **characterized in that** the power supply (30) comprises a second body (31), a second sliding portion (32), a second magnet (33) and a second contact (34); the second sliding portion (32) arranged on a side of the second body (31) close to the movable rail (10), both the second magnet (33) and the second contact (34) installed on a bottom wall of the second sliding portion (32), the second magnet (33) directly facing the iron-based conductive plate (40), and the second contact (34) abutting against circuits of the iron-based conductive plate (40).

15. The magnetic absorption track lamp as claimed in claim 10, which is **characterized in that** the magnetic absorption track lamp further comprises a rubber strip (50), and a second clamping portion (12) is formed on a side of the movable rail (10) away from the light emitting element (20), the rubber strip (50) comprising a clamping member (51) snapped into the second clamping portion (12).
